# EUROPEAN PATENT APPLICATION

(11) **EP 4 810 674 A1**
(43) Date of publication of application: **23.09.2026**
(21) Application number: 24893448.1
(22) Date of filing: 20.11.2024
(51) Int. Cl.: C30B 15/10, C30B 29/06, C04B 35/83

(54) **BRAIDED CRUCIBLE PREFORM, MANUFACTURING METHOD, AND CARBON/CARBON CRUCIBLE**

(30) Priority: 20.11.2023 CN 202311542015
(71) Applicant: Inner Mongolia Prosperity Materials Co., Ltd., Inner Mongolia 010080 (CN)
(72) Inventor: ZHOU, James Jian, Inner Mongolia 010080 (CN)
(74) Representative: Beck & Rössig European Patent Attorneys
(86) International application number: PCT/CN2024/133139
(87) International publication number: WO 2025/108291

(57) **Abstract**

A braided crucible preform, a method for manufacturing the same, and a carbon/carbon crucible are provided. The braided crucible preform comprises: a three-dimensional braided body; and a protective layer, which is disposed on an inner side and/or an outer side of the three-dimensional braided body, is connected to the three-dimensional braided body by needle-punching, and comprises fiber felt layers and winding layers that are alternately arranged. A density of the fiber felt layers gradually decreases in a direction away from the three-dimensional braided body, and/or a winding density of the winding layers gradually decreases in a direction away from the three-dimensional braided body. By configuring the braided crucible preform to include a three-dimensional braided body and a protective layer, and configuring the protective layer to include fiber felt layers and winding layers, the circumferential strength and corrosion resistance of the crucible can be ensured. By configuring the density of the fiber felt layers and/or the winding density of the winding layers to gradually decrease in a direction away from the three-dimensional braided body, carbon is facilitated to deposit on the three-dimensional braided body layer, and it is improved on the uniformity of carbon deposition and the overall strength of the crucible.

## Description

### TECHNICAL FIELD

The present invention belongs to the technical field of semiconductor and photovoltaic crystal growth equipment, and in particular relates to a braided crucible preform, a method for manufacturing the braided crucible preform, and a carbon/carbon crucible.

### BACKGROUND

In the production of single silicon crystal, the Czochralski method (CZ method) is currently widely used, which is a method of pulling the single silicon crystal from a melt in a vertical direction. In the production equipment, there is a component being a graphite crucible for supporting a quartz crucible placed in the graphite crucible. During use, due to the difference in the expansion coefficients of the quartz crucible and the graphite crucible, as well as silicon vapor reacting with graphite to cause erosion, the graphite crucible is prone to problems such as cracking and erosion-induced strength loss.

A carbon/carbon composite material is a carbon-fiber-reinforced carbon-matrix composite material that has excellent properties such as low density, high specific strength, high temperature resistance, low thermal expansion coefficient, good dimensional stability, strong structural designability, and corrosion resistance, and is widely used in military and civilian fields. In particular, there are advantages in the manufacture of large-size products and strong structural designability due to technological progress and the reduction of manufacturing costs, so carbon/carbon composite material has been extensively used in the thermal field components of the large monocrystalline silicon furnace in recent years. As an alternative to the graphite crucible, the carbon/carbon composite crucible is one of the key components of the thermal field system of the single crystal furnace.

During the pulling of single silicon crystal, the carbon/carbon composite crucible is in a mixed atmosphere of silicon vapor and inert gas. The silicon vapor deposits on the surface of the carbon/carbon composite crucible. Part of the silicon vapor reacts with the surface of the carbon/carbon composite material crucible to produce silicon carbide, or penetrates into the pores at a certain depth of the surface and reacts with the carbon therein to produce silicon carbide. Since the thermal expansion coefficient of silicon carbide does not match that of the carbon/carbon material, the silicon carbide is prone to flaking and pulverization, which affects further use of the carbon/carbon composite crucible. Accordingly, the service life of the thermal field components is affected.

Chinese Patent Application No. CN202111562959.0 discloses a quartz-fiber/carbon-fiber reinforced carbon-matrix composite crucible and a method for preparing the same. An intermediate layer of the crucible preform is composed of carbon fiber fabricated by alternately stacking carbon fiber plain-weave cloth or twill-weave cloth and short carbon fiber felt and performing needle punching, and inner and outer surface layers of the crucible preform are composed of quartz fiber fabricated by alternately stacking quartz fiber non-woven cloth and short quartz fiber webs and performing needle punching.

Although the above technical solution improves the strength and service life of the crucible to a certain extent, on the one hand, in this solution the intermediate layer is formed by needle-punching carbon fiber plain-weave cloth or twill-weave cloth together with short carbon fiber felt, so that the circumferential strength of the resulting crucible is poor; on the other hand, both the inner surface layer and the outer surface layer are formed by alternately stacking quartz fiber non-woven cloth and short quartz fiber felt and performing needle punching. For the structure of the crucible preform, it is not favorable for deposition into the intermediate layer during chemical vapor deposition, so the problem is apt to arise that the surface layers of the crucible have a higher deposition density, and the intermediate layer has a lower deposition density.

Therefore, a technical problem is solved by those skilled in the art for the braided crucible to achieve to ensure the silicon-erosion resistance of the crucible and improve the circumferential strength and deposition effect of the crucible.

### SUMMARY

The present invention provides a braided crucible preform. The braided crucible preform includes a three-dimensional braided body and a protective layer, and the protective layer includes a fiber felt layer and a winding layer, so the circumferential strength and the corrosion resistance of the crucible are ensured. By configuring the densities of the fiber felt layers and/or the winding densities of the winding layers to gradually decrease in a direction away from the three-dimensional braided body, this facilitates carbon deposition on the three-dimensional braided body, thereby solving the problems that existing crucibles having a protective layer have poor circumferential strength, a high deposition density in the protective layer, and a low deposition density in the intermediate layer.

To solve the above technical problems, the technical solutions of the present invention are as follows.

A braided crucible preform comprises: a three-dimensional braided body; and a protective layer, which is disposed on an inner side and/or an outer side of the three-dimensional braided body, and is connected to the three-dimensional braided body by needle-punching. The protective layer comprises fiber felt layers and winding layers that are alternately arranged, densities of the fiber felt layers is gradually decreased in a direction away from the three-dimensional braided body, and/or winding densities of the winding layers are gradually decreased in the direction away from the three-dimensional braided body.

Further, the winding layers comprise: a first winding layer in which carbon fiber filaments are extended along a circumferential direction of the three-dimensional braided body and are arranged along an axial direction of the three-dimensional braided body; and a second winding layer in which carbon fiber filaments are extended along the axial direction of the three-dimensional braided body and are arranged along the circumferential direction of the three-dimensional braided body.

Further, the winding layers comprises: a first winding layer in which carbon fiber filaments are extended along a circumferential direction of the three-dimensional braided body and are arranged along an axial direction of the three-dimensional braided body; or a second winding layer in which carbon fiber filaments are extended along the axial direction of the three-dimensional braided body and are arranged along the circumferential direction of the three-dimensional braided body.

Further, the protective layer comprises a first sub-protective layer and a second sub-protective layer sequentially arranged in the direction away from the three-dimensional braided body. The first sub-protective layer comprises fiber felt layers and first winding layers that are alternately arranged, and the second sub-protective layer comprises fiber felt layers and second winding layers that are alternately arranged.

Further, each of the first winding layer and the second winding layer comprises a first sub-winding layer and a second sub-winding layer, and the first sub-winding layer and the second sub-winding layer are alternately arranged in the direction away from the three-dimensional braided body. Winding directions of the carbon fiber filaments of the first sub-winding layer and of the second sub-winding layer are opposite to each other, and winding angles thereof are same, and the carbon fiber filaments of the first sub-winding layer and of the second sub-winding layer are configured to cross each other to form a mesh.

Further, a first fiber felt layer is disposed between adjacent first winding layers or between adjacent second winding layers, and between the first winding layer and the second winding layer; and/or a second fiber felt layer is disposed between the first sub-winding layer and the second sub-winding layer of a same first winding layer or a same second winding layer.

Further, densities of the first fiber felt layers are gradually decreased in the direction away from the three-dimensional braided body, and densities of the second fiber felt layers are same and less than or equal to the density of the first fiber felt layer that is farthest from the three-dimensional braided body. Or densities of the second fiber felt layers are gradually decreased in the direction away from the three-dimensional braided body, and a density of the second fiber felt layer that is closest to the three-dimensional braided body is less than or equal to the density of the first fiber felt layer that is farthest from the three-dimensional braided body.

Further, the three-dimensional braided body comprises a sidewall extending vertically, and a bottom extending from a lower end of the sidewall and curving toward an axis of the three-dimensional braided body; the first sub-protective layer is disposed on the sidewall, and the second sub-protective layer is disposed on the sidewall and the bottom.

Further, a filling layer is disposed between the second sub-protective layer and the bottom of the three-dimensional braided body and at a corner between the bottom and the sidewall. The filling layer comprises a fiber felt layer, or comprises fiber felt layers and carbon cloth layers that are alternately arranged. A thickness of the filling layer is greater than or equal to a thickness of the first sub-protective layer.

Further, the thickness of the fiber felt layers is gradually decreased in the direction away from the three-dimensional braided body.

The present invention also provides a method for manufacturing the above-described braided crucible preform, which comprises the following steps:
S1: first laying an EVA needling pad on a wooden mold, then disposing a layer of fiber felt on the EVA needling pad, and alternately stacking winding layers and fiber felt layers on an outside of the layer of the fiber felt layer, so as to form an inner protective layer;
S2: sleeving the three-dimensional braided body on an outside of the inner protective layer;
S3: alternately stacking winding layers and fiber felt layers on an outside of the three-dimensional braided body so as to form an outer protective layer, and disposing a layer of fiber felt layer on an outside of the outer protective layer; and
S4: performing needle-punching.

By adopting the above technical solutions, the present invention has the following beneficial effects compared with the prior art.
1. In present invention, by configuring the braided crucible preform to include a three-dimensional braided body and a protective layer, and configuring the protective layer to include fiber felt layers and winding layers, the circumferential strength and the corrosion resistance of the crucible are ensured. By configuring the densities of the fiber felt layers and/or the winding densities of the winding layers to gradually decrease in a direction away from the three-dimensional braided body, the present invention facilitates carbon deposition on the three-dimensional braided body layer, improves the uniformity of carbon deposition, and improves the overall strength of the crucible.
2. In invention, by configuring the fiber felt layers to include first fiber felt layers and second fiber felt layers, and configuring the densities of the second fiber felt layers to be less than or equal to the density of the first fiber felt layer that is farthest from the three-dimensional braided body, it can be improved on the connection effect between the layers of the protective layer and between the protective layer and the three-dimensional braided body, while ensuring the deposition effect. Thereby it is further improved on the overall strength of the crucible.
3. By providing the filling layer, the present invention can enhance the strength of the bottom of the crucible, improve the uniformity of the thickness of the bottom and the sidewall, and improve the service life of the crucible.

The specific embodiments of the present invention are described below in further detail with reference to the accompanying drawings.

### BRIEF DESCRIPTION OF THE DRAWINGS

The accompanying drawings form a part of the present invention and are used to further understand the present invention. The illustrative embodiments of the present invention and descriptions thereof are used to explain the present invention, but do not constitute an undue limitation on the present invention. Obviously, the drawings in the following description are merely some embodiments, and for those skilled in the art, other drawings may also be obtained based on these drawings without creative effort. In the drawings:
Fig. 1 is a schematic structural view of a first three-dimensional braided body in an embodiment of the present invention;
Fig. 2 is a cross-sectional view of a first three-dimensional braided body in the embodiment of the present invention;
Fig. 3 is a schematic structural view of a second three-dimensional braided body in an embodiment of the present invention;
Fig. 4 is a schematic structural view of a third three-dimensional braided body in an embodiment of the present invention;
Fig. 5 is a schematic structural view of a protective layer in an embodiment of the present invention;
Fig. 6 is a schematic structural view of a second winding layer in an embodiment of the present invention.

Main components in the drawings:
1, three-dimensional braided body; 11, sidewall; 12, bottom; 2, protective layer; 21, first sub-protective layer; 22, second sub-protective layer; 23, filling layer; 3, carbon fiber filament; 31, first carbon fiber filament; 32, second carbon fiber filament; 4, axial rib; 5, winding layer; 51, second winding layer.

It should be noted that these drawings and written descriptions are not intended to limit the scope of the present invention in any manner, but rather to explain the present invention to those skilled in the art with reference to specific embodiments.

### DETAILED DESCRIPTION OF EMBODIMENTS

To make the objectives, technical solutions and advantages of the embodiments of the present invention clearer, the technical solutions in the embodiments are clearly and completely described below with reference to the drawings in the embodiments of the present invention. The following embodiments are used to illustrate the present invention, but are not used to limit the scope of the present invention.

In the description of the present invention, it should be noted that the orientations or positional relationships indicated by the terms "upper", "lower", "front", "rear", "left", "right", "vertical", "inner", "outer" and the like are based on the orientations or positional relationships shown in the drawings, and are intended merely to facilitate the description of the present invention and to simplify the description, rather than to indicate or imply that the devices or elements must have a specific orientation or be constructed and operated in a specific orientation. Therefore, it should not be construed as limitations on the present invention.

In the description of the present invention, it should be noted that, unless otherwise expressly specified and limited, the terms "install", "couple" and "connect" should be interpreted broadly. For example, the connection may be a fixed connection, a detachable connection, or an integral connection; it may be a mechanical connection or an electrical connection; it may be a direct connection or an indirect connection through an intermediate medium. For those skilled in the art, the specific meanings of the above terms in the present invention can be understood according to specific situations.

### Embodiment 1

The carbon/carbon composite crucible, i.e., C/C crucible, is a carbon-based protective crucible with strong designability and excellent performance. It is a high-tech pribuct made of a composite material composed of high-strength carbon fibers and a carbon matrix. Compared with graphite products, C/C crucible is energy-saving, saves a substantial amount of material, and has excellent performances including long service life, high specific strength, high temperature resistance, corrosion resistance, low thermal expansion coefficient, thermal shock resistance, and resistance to deformation and cracking. It is an ideal upgraded product to replace the graphite crucible in a single crystal furnace. As an important component for supporting the quartz crucible containing silicon material in the thermal field system of the single silicon crystal furnace used in the Czochralski method, its demand is increasing.

A manufacturing process of a carbon/carbon crucible includes: preparing a preform of carbon/carbon crucible, placing the preform in a deposition furnace for carbon deposition, and placing a deposited semi-finished product in a graphitization furnace for graphitization.

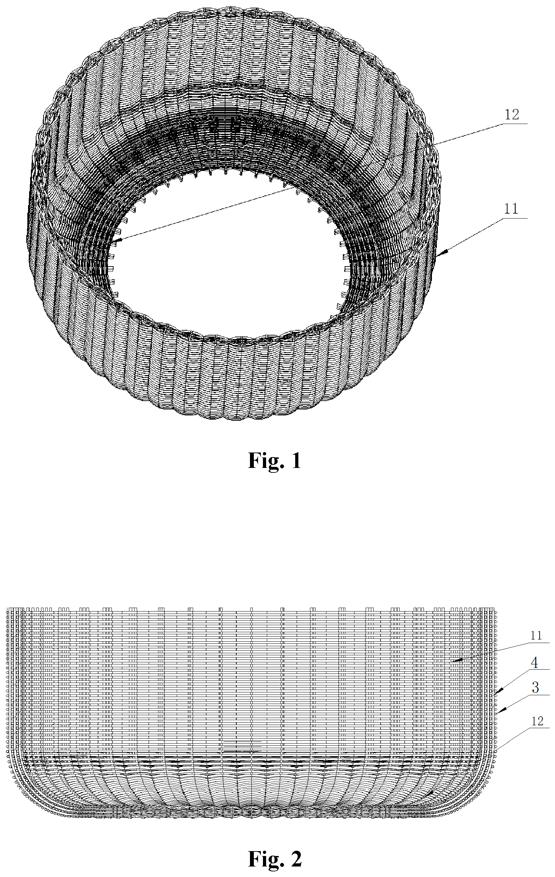

As shown in Figs. 1 to 6, in an embodiment of the present invention, a braided crucible preform comprises a three-dimensional braided body 1 and a protective layer 2 disposed on an inner side and/or an outer side of the three-dimensional braided body 1.

Specifically, as shown in Fig. 1, the three-dimensional braided body 1 is an annular hollow structure braided from one or more carbon fiber filaments 3. An opening is provided at an upper of the three-dimensional braided body 1, and a lower thereof is bowl-shaped. A through hole being coaxial with the three-dimensional braided body 1 is provided in a middle of the lower, and a diameter of the opening on the upper of the three-dimensional braided body 1 is larger than a diameter of the through hole on the lower.

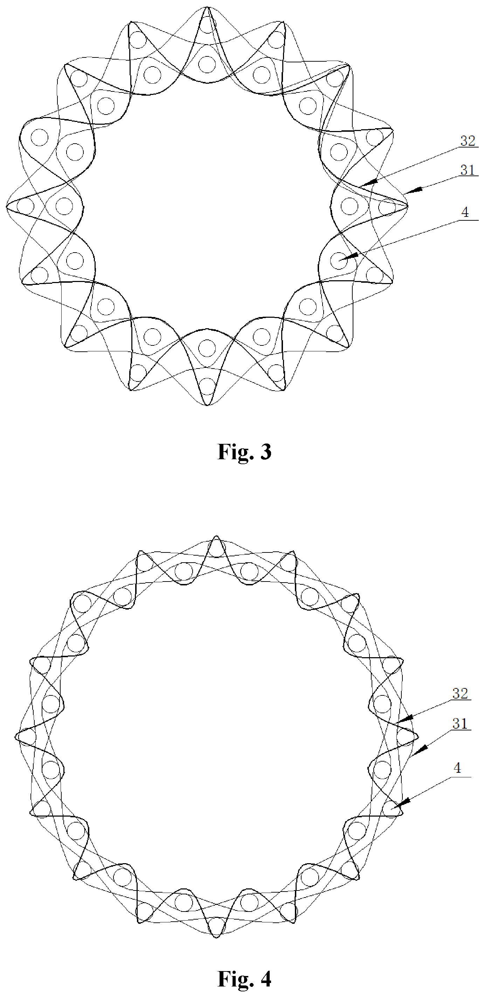

As shown in Figs. 3 and 4, in the embodiment, axial rids 4 are provided in at least two circles along a radial direction of the three-dimensional braided body 1, so the axial supporting strength of the braided crucible can be improved. A first carbon fiber filament 31 is configured to spirally weave on the axial ribs 4 on a same circle, and a second carbon fiber filament 32 is configured to spirally weave on the axial ribs 4 on adjacent circles, and the crests and troughs of the first carbon fiber filament 31 and of the second carbon fiber filament 32 cross each other, so that the axial ribs 4 are connected as a whole to form the three-dimensional braided body 1, which can improve the circumferential supporting strength of the braided crucible. Therefore the braided crucible preform has multiple layers of carbon fiber composite material arranged along the radial direction of the three-dimensional braided body 1, thereby improving the overall supporting strength and service life of the braided crucible.

In some embodiments, the three-dimensional braided body 1 comprises a plurality of axial ribs 4 arranged at intervals around an axis of the three-dimensional braided body 1 and the carbon fiber filament 3 is spirally wound around the axial ribs 4. At least two circles of the axial ribs 4 are arranged along the radial direction of the braided crucible preform. The axial ribs 4 on the same circle are connected by the first carbon fiber filament 31, the axial ribs 4 on adjacent circles are connected by the second carbon fiber filament 32, and the crests and troughs of the first carbon fiber filaments 31 and of the second carbon fiber filaments 32 cross each other.

As shown in Fig. 3, in the embodiment, the axial ribs 4 on adjacent circles correspond one-to-one.

In the embodiment, the crests and troughs of the first carbon fiber filament 31 on two adjacent circles correspond one-to-one. The crests of the second carbon fiber filament 32 cross the troughs of the first carbon fiber filament 31 on both the inner and outer circles simultaneously, and the troughs of the second carbon fiber filament 32 cross the crests of the first carbon fiber filament 31 on both the inner and outer circles simultaneously.

Preferably, in the embodiment, the axial ribs 4 on the same circle are connected by two sets of first carbon fiber filaments 31, and the crests and troughs of the two sets of first carbon fiber filaments 31 cross each other; and/or the axial ribs 4 on adjacent circles are connected by two sets of second carbon fiber filaments 32, and the crests and troughs of the two sets of second carbon fiber filaments 32 cross each other.

Alternatively, as shown in Fig. 4, in the embodiment, the axial ribs 4 on adjacent circles are arranged in a staggered manner.

In the embodiment, the troughs of the first carbon fiber filaments 31 on the outer circle cross the crests of the second carbon fiber filaments 32; and the crests of the first carbon fiber filaments 31 on the inner circle cross the troughs of the second carbon fiber filaments 32.

Specifically, the axial ribs 4 on the same circle are connected by two sets of first carbon fiber filaments 31, and the crests and troughs of the two sets of first carbon fiber filaments 31 cross each other. Two adjacent crests of the second carbon fiber filaments 32 cross the troughs of the two sets of first carbon fiber filaments 31 on the outer circle, respectively; and two adjacent troughs of the second carbon fiber filaments 32 cross the crests of the two sets of first carbon fiber filaments 31 on the inner circle, respectively.

In the embodiment, the axial ribs 4 on the same circle are connected by two sets of first carbon fiber filaments 31 and the crests and troughs of the two sets of first carbon fiber filaments 31 cross each other, and the first carbon fiber filaments 31 and the second carbon fiber filaments 32 are arranged in a staggered manner along the length direction of the axial ribs 4, so the circumferential strength of the braided crucible can be further improved, and the service life of the braided crucible can be improved.

Preferably, in the embodiment, the first carbon fiber filaments 31 and the second carbon fiber filaments 32 are arranged in a staggered manner along the length direction of the axial ribs 4; and the first carbon fiber filaments 31 on adjacent circles correspond one-to-one in a direction perpendicular to the length of the axial ribs 4.

In other embodiments, the three-dimensional braided body 1 is formed by stacking a plurality of two-dimensional braided structures.

As shown in Figs. 1 and 2, in the embodiment, the axial ribs 4 of the two-dimensional braided structure are on the same circle, and a plurality of axial ribs are arranged at intervals around the axis of the two-dimensional braided structure. The axial ribs 4 are spirally wound by two sets of carbon fiber filaments 3 alternately arranged, and the crests and troughs of the two sets of carbon fiber filaments 3 cross each other.

The two-dimensional braided structure comprises a plurality of layers arranged along the radial direction, and an outer circumferential wall of an inner two-dimensional braided structure is fitted against an inner circumferential wall of an adjacent outer two-dimensional braided structure.

In the embodiment, the adjacent two two-dimensional braided structures are connected by needle-punching. Specifically, the protective layer 2 may be disposed on an inner side of the innermost two-dimensional braided structure and/or on an outer side of the outermost two-dimensional braided structure, and the entire braided crucible preform is needle-punched. Alternatively, the stacked two-dimensional braided body structures may first be needle-punched to form a three-dimensional braided body 1, and then the protective layer 2 is disposed on the inner side and/or the outer side thereof.

Preferably, in the embodiment, a layer of fiber felt is disposed between adjacent two two-dimensional braided structures to further enhance the stability of the overall structure of the three-dimensional braided body 1.

In the embodiment, the protective layer 2 is disposed on the inner side and/or the outer side of the three-dimensional braided body 1, is connected to the three-dimensional braided body 1 by needle-punching, and comprises fiber felt layers and winding layers 5 that are alternately arranged. Densities of the fiber felt layers are gradually decreased in a direction away from the three-dimensional braided body 1, and/or winding densities of the winding layers 5 are gradually decreased in the direction away from the three-dimensional braided body 1. The alternating arrangement of the fiber felt layers and the winding layers 5 is specifically that the fiber felt layers and the winding layers 5 are alternately stacked, that is, one or more winding layers 5 are disposed between two adjacent fiber felt layers. The braided crucible preform includes the three-dimensional braided body 1 and the protective layer 2, and the protective layer 2 includes the fiber felt layers and the winding layers 5, so the circumferential strength and corrosion resistance of the crucible can be ensured. By configuring the densities of the fiber felt layers and/or the winding densities of the winding layers 5 to gradually decrease in the direction away from the three-dimensional braided body 1, it is facilitated that carbon is deposited on the three-dimensional braided body, the uniformity of carbon deposition is improved, and the overall strength of the crucible is improved.

Specifically, when the braided crucible preform is subjected to chemical vapor deposition, carbon is deposited from a surface layer of sidewall of the braided crucible preform toward an inner layer of the sidewall. By configuring the densities of the fiber felt layers and the winding densities of the winding layers 5 to gradually decrease in the direction away from the three-dimensional braided body 1, the carbon-containing gas is more conducive to flow into the inner layer of the sidewall of the braided crucible preform for depositing carbon, so as to ensure the deposition effect on the inner layer of the three-dimensional braided body 1, thereby improving the overall strength of the crucible.

In the embodiment, the winding layers 5 comprises a first winding layer in which the carbon fiber filaments 3 are extended along the circumferential direction of the three-dimensional braided body 1 and are arranged along the axial direction of the three-dimensional braided body 1, and a second winding layer 51 in which the carbon fiber filaments 3 are extended along the axial direction of the three-dimensional braided body 1 and are arranged along the circumferential direction of the three-dimensional braided body 1.

Specifically, during the winding of the carbon fiber filaments 3 of the first winding layer, one end of the carbon fiber filaments 3 is first fixed to a first end of a wooden mold; then the wooden mold is rotated, while at the same time the carbon fiber filaments 3 are tensioned and moved toward a second end of the wooden mold, so that the carbon fiber filaments 3 are uniformly wound on the wooden mold with a certain tension. Preferably, in the embodiment, the tension of the carbon fiber filaments 3 is controlled by a tensioner.

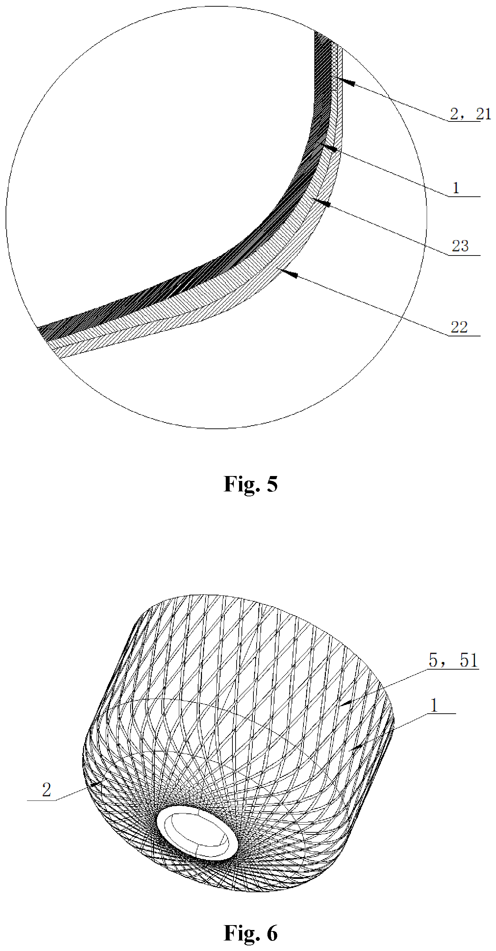

As shown in Fig. 6, in the embodiment, a winding process of the carbon fiber filaments 3 of the second winding layer 51 is as follows.

A circle of support columns is first disposed at each of a first end and a second end of the wooden mold. The support columns at the first end and the second end of the wooden mold are on a same circle respectively, and are uniformly arranged along a circumferential direction of the wooden mold. One end of the carbon fiber filaments 3 of the second winding layers 51 is fixed to any one of the support columns, and the carbon fiber filaments are then wound toward the support columns at the other end of the wooden mold.

Specifically, the support columns may be nails. The nails disposed at the first end of the wooden mold may be spaced apart from the opening on the upper of the three-dimensional braided body 1, or fitted against the opening on the upper of the three-dimensional braided body 1, and the nails disposed at the second end of the wooden mold may be spaced apart from the through hole one the lower of the three-dimensional braided body 1, or fitted against the through hole on the lower of the three-dimensional braided body 1.

One end of the carbon fiber filaments 3 is fixed to any one of the nails disposed at the first end of the wooden mold, and the carbon fiber filaments is then wound toward the nails at the second end, being wound around successively to one circuit, so as to form the second winding layers 51 extending along the axial direction of the three-dimensional braided body 1 and arranged along the circumferential direction of the three-dimensional braided body 1.

In the embodiment, the tension of the carbon fiber filaments 3 of the second winding layers 51 is controlled by a tensioner.

In the embodiment, the carbon fiber filament 3 is in a flat shape. In the winding process of the carbon fiber filament 3, the carbon fiber filament 3 is fitted parallel to the circumferential wall of the wooden mold.

In the embodiment, an angle between the carbon fiber filaments 3 of the first winding layer and of the second winding layer 51 and the axis of the three-dimensional braided body 1 is greater than 0° and less than 90°. In the embodiment, the carbon fiber filaments 3 are wound on the three-dimensional braided body 1, the integrity of the carbon fiber filaments 3 can be ensured, thereby further improving the strength of the protective layer 2.

Preferably, as shown in Fig. 5, in the embodiment, the protective layer 2 comprises a first sub-protective layer 21 and a second sub-protective layer 22 sequentially arranged in the direction away from the three-dimensional braided body 1. The first sub-protective layer 21 comprises fiber felt layers and first winding layers that are alternately arranged, and the second sub-protective layer 22 comprises fiber felt layers and second winding layers 51 that are alternately arranged. Thus, the second winding layer 51, which has a smaller winding density, is disposed on the side farther from the three-dimensional braided body 1; and the first winding layer, which has a larger winding density, is disposed on the side closer to the three-dimensional braided body 1, so that during carbon deposition, it is more conducive to deposition into the inner layer of the braided crucible preform, thereby improving the uniformity of deposition.

In the embodiment, each of the first winding layer and the second winding layer 51 comprises a first sub-winding layer and a second sub-winding layer. The first sub-winding layer and the second sub-winding layer are alternately arranged in the direction away from the three-dimensional braided body 1, the winding directions of the carbon fiber filaments 3 of the first sub-winding layer and of the second sub-winding layer are opposite and the winding angles thereof are the same, and the carbon fiber filaments 3 of the first sub-winding layer and of the second sub-winding layer cross each other to form a mesh.

Specifically, the carbon fiber filaments of one of the first sub-winding layer and the second sub-winding layer is wound clockwise in a direction from the first end toward the second end of the three-dimensional braided body, while the carbon fiber filaments of the other of the first sub-winding layer and the second sub-winding layer is wound counterclockwise in the direction from the first end toward the second end of the three-dimensional braided body. That is, the carbon fiber filaments of the first sub-winding layer and of the second sub-winding layer are arranged to cross each other. The carbon fiber filaments of the first sub-winding layer and of the second sub-winding layer are interlaced with each other to form a mesh, so it is improved on the winding effect on the fiber felt layer. This is advantageous for increasing the angle between the carbon fiber filaments 3 of the first sub-winding layer and of the second sub-winding layer and the axis of the three-dimensional braided body 1, and further for increasing the spacing between the turns of carbon fiber filaments 3 of the first sub-winding layer and of the second sub-winding layer. In other words, the winding density of the winding layer 5 can be increased while ensuring the winding effect on the fiber felt layer.

Preferably, in the embodiment, the first sub-winding layer and the second sub-winding layer are alternatively arranged; and the angles between the carbon fiber filaments 3 of the first sub-winding layer and of the second sub-winding layer and the axis of the three-dimensional braided body 1 are the same.

Preferably, in the embodiment, a first fiber felt layer is disposed between adjacent first winding layers or between adjacent second winding layers 51, and between the first winding layer and the second winding layer 51; and/or a second fiber felt layer is disposed between the first sub-winding layer and the second sub-winding layer of the same first winding layer or the same second winding layer 51.

Preferably, in the embodiment, the fiber felt layers include first fiber felt layers and second fiber felt layers, and densities of the first fiber felt layers is gradually decreased in the direction away from the three-dimensional braided body 1.

In the embodiment, the densities of the second fiber felt layers are the same and are less than or equal to the density of the first fiber felt layer that is farthest from the three-dimensional braided body 1. Or the densities of the second fiber felt layers are gradually decreased in the direction away from the three-dimensional braided body 1, and the density of the second fiber felt layer that is closest to the three-dimensional braided body 1 is less than or equal to the density of the first fiber felt layer that is farthest from the three-dimensional braided body 1.

In the embodiment, the fiber felt layers include first fiber felt layers and second fiber felt layers, and the densities of the second fiber felt layers are less than or equal to the density of the first fiber felt layer that is farthest from the three-dimensional braided body 1, so that the connection effect between the layers of the protective layer 2 and between the protective layer 2 and the three-dimensional braided body 1 can be improved while ensuring the deposition effect, thereby further improving the overall strength of the crucible.

Preferably, in the embodiment, a thickness of the fiber felt layers is gradually decreased in the direction away from the three-dimensional braided body 1.

Further preferably, in the embodiment, the thickness of first fiber felt layers is gradually decreased in the direction away from the three-dimensional braided body 1, and the thicknesses of the second fiber felt layers is the same and are less than or equal to the thickness of the first fiber felt layer that is farthest from the three-dimensional braided body 1. Or the thickness of the short second fiber felt layers is gradually decreased in the direction away from the three-dimensional braided body 1, and the thickness of the second fiber felt layer that is closest to the three-dimensional braided body 1 is less than or equal to the thickness of the first fiber felt layer that is farthest from the three-dimensional braided body 1.

In the embodiment, the three-dimensional braided body 1 comprises a sidewall 11 extending vertically, and a bottom 12 extending from a lower end of the sidewall 11 and curving toward the axis of the three-dimensional braided body 1. The first sub-protective layer 21 is disposed on the sidewall 11, and the second sub-protective layer 22 is disposed on the sidewall 11 and the bottom 12. So the winding layer 5 is easier wound, and the overall stability of the protective layer 2 is improved. Since the density of the second winding layer 51 is gradually increased in an extension direction from the sidewall 11 toward the bottom 12, the first winding layer is only arranged on the sidewall 11 to make the overall density of the winding layer 5 more uniform, thereby improving the deposition effect of the braided crucible preform.

Preferably, in the embodiment, the density of the first winding layer is configured to gradually decrease in the direction toward the bottom 12, that is, the angle between the carbon fiber filaments 3 of the first winding layer and the axis of the three-dimensional braided body 1 is gradually increased in the direction toward the bottom 12, so as to further improve the uniformity of the overall density of the winding layer 5 of the protective layer 2 and further improve the deposition effect of the braided crucible preform.

Preferably, in the embodiment, the protective layer 2 further comprises a filling layer 23. Specifically, the filling layer 23 is disposed between the second sub-protective layer 22 and the bottom 12 of the three-dimensional braided body 1 and at a corner between the bottom 12 and the sidewall 11, such that the thicknesses of the bottom 12 and the sidewall 11 are made uniform, and the strength of the bottom of the crucible can be further enhanced. Therefore it is improved on the service life of the crucible.

Preferably, in the embodiment, the filling layer 23 comprises a fiber felt layer, or comprises fiber felt layers and carbon cloth layers that are alternately arranged.

Further preferably, in the embodiment, a thickness of the filling layer 23 is greater than or equal to the thickness of the first sub-protective layer 21.

Preferably, in the embodiment, a fiber felt layer is disposed at the innermost layer of the protective layer 2 on the inner side of the three-dimensional braided body 1 and the outermost layer of the protective layer 2 on the outer side of the three-dimensional braided body 1, and then needle-punching is performed, so that the second winding layer 51 can be stably retained on the preform.

### Embodiment 2

The embodiment provides a method for manufacturing the above-described braided crucible preform. The method for manufacturing the braided crucible preform is as follows.
S1: Arranging the inner protective layer;

First, an EVA needling pad is laid on a wooden mold, then a fiber felt layer is disposed on the EVA needling pad, and then winding layers 5 and fiber felt layers are alternately stacked. Specifically, a second sub-protective layer 22, a filling layer 23 and a first sub-protective layer 21 are sequentially disposed on an outer periphery of the EVA needling pad, such that the outer shape of the inner protective layer formed matches the inner shape of the three-dimensional braided body 1.

Preferably, in the embodiment, a second winding layer 51 is disposed at the outermost layer of the inner protective layer, so as to stably retain a filling layer 23 on the wooden mold.

S2: Sleeving the three-dimensional braided body 1 on an outside of the inner protective layer.

S3: Arranging an outer protective layer;
A first sub-protective layer 21, a filling layer 23 and a second sub-protective layer 22 are sequentially disposed on the outside of the three-dimensional braided body 1, and then a fiber felt layer is disposed on an outermost layer of the outer protective layer.

S4: Needle-punching.

After the inner protective layer, the three-dimensional braided body 1 and the outer protective layer are sequentially arranged, the entire braided crucible preform is needle-punched, so that the layers of the protective layer 2, and the protective layer 2 and the three-dimensional braided body 1, are connected as a whole, forming the braided crucible preform, and then the preform is demolded.

In the embodiment, after the braided crucible preform is manufactured, it is sequentially subjected to chemical vapor deposition and graphitization treatments to obtain a crucible.

A process of the chemical vapor deposition comprises: using natural gas as a carbon source gas and nitrogen as a carrier gas; a reaction temperature of the vapor deposition process being 800-1100 °C; a flow rate of natural gas being 40-110 L/min; and a deposition time being 100-200 h.

A graphitization process comprises: placing a crucible green body obtained by chemical vapor deposition in a graphitization furnace at a temperature of about 2000 °C, and maintaining the temperature in a vacuum environment of the graphitization furnace for 5-10 hours.

In the following experimental examples, an inner protective layer and an outer protective layer each having an apparent density of 0.42 to 0.5 g/cm³ were respectively disposed on the inner side and the outer side of the three-dimensional braided body 1 of the crucible preform. The thickness of the three-dimensional braided body 1 was 8-16 mm, and the density thereof was 0.5-0.6 g/cm³. The thickness of the protective layer was 2 to 6 mm, and a weight ratio of the fiber felt layer to the winding layer in the protective layer was 1:5.

### Experimental Example 1:

The experimental example tests the performance of a carbon/carbon crucible prepared from the braided crucible preform of Embodiment 1 through deposition and graphitization processes. The method for preparing the carbon/carbon crucible comprises the following steps:
S01: Deposition: The braided crucible preform of Embodiment 1 was placed in a deposition furnace for chemical vapor deposition. An inner protective layer and an outer protective layer each having an apparent density of 0.45 g/cm³ were respectively disposed on the inner side and the outer side of the three-dimensional braided body 1 of the crucible preform; the thickness of each of the inner protective layer and the outer protective layer was 4 mm; and the weight ratio of the fiber felt layer to the winding layer in the protective layer was 1:5. The thickness of the three-dimensional braided body 1 was 10 mm, and its density was 0.6 g/cm³.

During the process of the vapor deposition, natural gas (containing a methane volume content of 85%) was used as the carbon source gas and nitrogen was used as the carrier gas. Nitrogen at a flow rate of 5 L/min and natural gas at a flow rate of 80 L/min were flowed into a deposition furnace through the bottom of the deposition furnace. A temperature of the process of the vapor deposition was about 900 °C, and a deposition time was 200 h.

S02: Graphitization: The crucible green body obtained in step S01 was placed in a graphitization furnace for graphitization treatment to obtain a carbon/carbon crucible. A temperature of the graphitization treatment was about 2000 °C, and a time for keeping the temperature was 8 hours.

The carbon/carbon crucible was tested: the density of the inner layer and the outer layer was 1.55 g/cm³, the density of the intermediate layer was 1.50 g/cm³, the flexural strength was 179 MPa, and the service life of the carbon/carbon crucible was 200 days.

### Comparative Example 1:

The method for preparing the crucible preform in the comparative example differs from Experimental Example 1.

Fiber felt layers with a density of 0.45 g/cm³ were arranged on the inner side and the outer side of the three-dimensional braided body 1 by needle-punching respectively, to form protective layers with a thickness of 4 mm. The thickness of the three-dimensional braided body was 10 mm, and its density was 0.6 g/cm³.

The crucible preform was subjected to vapor deposition and graphitization treatments using the same process and parameters as in Experimental Example 1 to obtain a carbon/carbon crucible.

### Comparative Example 2:

The method for preparing the crucible preform in the comparative example differs from Experimental Example 1.

A protective layer formed by alternately stacking fiber felt layers and carbon cloth layers was arranged on each of the inner side and the outer side of the three-dimensional braided body 1 by needle-punching. The apparent density of the protective layer was 0.45 g/cm³, the thickness of the protective layer was 4 mm, and the weight ratio of the fiber felt to the carbon cloth was 1:5. The thickness of the three-dimensional braided body was 10 mm, and its density was 0.6 g/cm³.

The crucible preform was subjected to vapor deposition and graphitization treatments using the same process and parameters as in Experimental Example 1 to obtain a carbon/carbon crucible.

### Comparative Example 3:

The method for preparing the intermediate layer in the comparative example differs from Experimental Example 1.

Carbon cloth and fiber felt were needle-punched into a whole to form the intermediate layer, the thickness of which was 10 mm and the density of which was 0.6 g/cm³.

A protective layer was respectively disposed on each of the inner side and the outer side of the intermediate layer. The structure and preparation method of the protective layer are the same as those of the inner protective layer and the outer protective layer on the inner side and the outer side of the three-dimensional braided body 1 in Experimental Example 1. The apparent density of the protective layer was 0.45 g/cm³, the thickness of the protective layer was 4 mm, and the weight ratio of the fiber felt layer to the winding layer in the protective layer was 1:5.

The crucible preform was subjected to vapor deposition and graphitization treatments using the same process and parameters as in Experimental Example 1 to obtain a carbon/carbon crucible.

The performance of the carbon/carbon crucibles prepared in Experimental Example 1 and Comparative Examples 1 to 3 was tested, and the results are shown in the following table.

| Sample | | Experimental Example 1 | Comparative Example 1 | Comparative Example 2 | Comparative Example 3 |
|---|---|---|---|---|---|
| Density (g/cm³) | Intermediate layer | 1.50 | 1.39 | 1.40 | 1.42 |
| | Surface layer | 1.55 | 1.62 | 1.61 | 1.57 |
| Service life | | 200 days | 180 days | 188 days | 192 days |
| Flexural strength (MPa) | | 179 | 135 | 140 | 146 |

In the present invention, the service life of the crucible refers to the total accumulated time used for pulling single silicon crystal, and the total accumulated time is measured from the start of use until cracks first appear on the surface layer of the crucible.

The density was tested in accordance with GB/T 2997-2015 (Test method for bulk density, apparent porosity and true porosity of dense shaped refractory products).

The flexural strength was determined in accordance with GB/T 3001-2007 (Test method for flexural strength at room temperature).

The foregoing is only a description of preferred embodiments of the present invention, and is not intended to limit the present invention in any form. Although the present invention disclosed above by way of preferred embodiments, these are not intended to limit the present invention. Any person skilled in the art may, without departing from the scope of the technical solutions of the present invention, make use of the content disclosed above to make minor modifications or design equivalent embodiments with equivalent variations. All simple modifications, equivalent variations, and modifications made to the above embodiments in accordance with the technical essence of the present invention, without departing from the content of the solutions of the present invention, still fall within the scope of the solutions of the present invention.

## Claims

1. A braided crucible preform, comprising:
a three-dimensional braided body (1); and
a protective layer (2), disposed on an inner side and/or an outer side of the three-dimensional braided body (1), connected to the three-dimensional braided body (1) by needle-punching, and comprising fiber felt layers and winding layers (5) that are alternately arranged,
wherein winding densities of the winding layers (5) are gradually decreased in a direction away from the three-dimensional braided body (1).

2. The braided crucible preform according to claim 1, wherein the winding layers (5) comprises:
a first winding layer, in which carbon fiber filaments are extended along a circumferential direction of the three-dimensional braided body (1) and are arranged along an axial direction of the three-dimensional braided body (1); and
a second winding layer (51), in which carbon fiber filaments are extended along the axial direction of the three-dimensional braided body (1) and are arranged along the circumferential direction of the three-dimensional braided body (1).

3. The braided crucible preform according to claim 1, wherein the winding layers (5) comprises:
a first winding layer, in which carbon fiber filaments are extended along a circumferential direction of the three-dimensional braided body (1) and are arranged along an axial direction of the three-dimensional braided body (1); or
a second winding layer (51), in which carbon fiber filaments are extended along the axial direction of the three-dimensional braided body (1) and are arranged along the circumferential direction of the three-dimensional braided body (1).

4. The braided crucible preform according to claim 2 or 3, wherein each of the first winding layer and the second winding layer (51) comprise a first sub-winding layer and a second sub-winding layer, the first sub-winding layer and the second sub-winding layer are alternately arranged in the direction away from the three-dimensional braided body (1),
winding directions of the carbon fiber filaments of the first sub-winding layer and of the second sub-winding layer are opposite to each other, and winding angles thereof are same, and
the carbon fiber filaments of the first sub-winding layer and of the second sub-winding layer cross each other to form a mesh.

5. The braided crucible preform according to claim 4, wherein
a first fiber felt layer is disposed between adjacent first winding layers or between adjacent second winding layers (51), and between the first winding layer and the second winding layer (51); and/or
a second fiber felt layer is disposed between the first sub-winding layer and the second sub-winding layer of a same first winding layer or a same second winding layer (51).

6. The braided crucible preform according to claim 5, wherein densities of the fiber felt layers are gradually decreased in the direction away from the three-dimensional braided body (1); or
densities of first fiber felt layers are gradually decreased in the direction away from the three-dimensional braided body (1), and densities of second fiber felt layers is same and are less than or equal to the density of the first fiber felt layer that is farthest from the three-dimensional braided body (1); or
the densites of the second fiber felt layers are gradually decreased in the direction away from the three-dimensional braided body (1), and the density of the second fiber felt layer that is closest to the three-dimensional braided body (1) is less than or equal to the density of the first fiber felt layer that is farthest from the three-dimensional braided body (1).

7. The braided crucible preform according to claim 3, wherein the fiber felt layers and first winding layers are alternately arranged to form a first sub-protective layer (21), and the fiber felt layers and second winding layers (51) are alternately arranged to form a second sub-protective layer (22); and
the first sub-protective layer (21) and the second sub-protective layer (22) are sequentially arranged in the direction away from the three-dimensional braided body (1).

8. The braided crucible preform according to claim 7, wherein the three-dimensional braided body (1) comprises a sidewall (11) extending vertically, and a bottom (12) extending from a lower end of the sidewall (11) and curving toward an axis of the three-dimensional braided body (1),
the first sub-protective layer (21) is disposed on the sidewall (11), and the second sub-protective layer (22) is disposed on the sidewall (11) and the bottom (12).

9. The braided crucible preform according to claim 8, wherein a filling layer (23) is disposed between the second sub-protective layer (22) and the bottom (12) of the three-dimensional braided body (1) and at a corner between the bottom (12) and the sidewall (11),
the filling layer (23) comprises a fiber felt layer, or the filling layer (23) comprises fiber felt layers and carbon cloth layers that are alternately arranged;
preferably, a thickness of the filling layer (23) is greater than or equal to a thickness of the first sub-protective layer (21).

10. The braided crucible preform according to claim 5, wherein a thickness of the fiber felt layers is gradually decreased in the direction away from the three-dimensional braided body (1); or
a thickness of the first fiber felt layer is gradually decreased in the direction away from the three-dimensional braided body (1), and thicknesses of the second fiber felt layer are same and are less than or equal to the thickness of the first fiber felt layer that is farthest from the three-dimensional braided body (1); or
a thickness of the second fiber felt layer is gradually decreased in the direction away from the three-dimensional braided body (1), and the thickness of the second fiber felt layer that is closest to the three-dimensional braided body (1) is less than or equal to the thickness of the first fiber felt layer that is farthest from the three-dimensional braided body (1).

11. The braided crucible preform according to any one of claims 1 to 3, wherein the three-dimensional braided body (1) comprises:
axial ribs (4), arranged at intervals around an axis of the three-dimensional braided body (1), wherein at least two circles of the axial ribs (4) are arranged along a radial direction of the three-dimensional braided body (1),
first carbon fiber filament (31), for spirally winding around the axial ribs (4) on a same circle, and
second carbon fiber filament (32), for spirally winding around the axial ribs (4) on adjacent circles, wherein crests and troughs of the first carbon fiber filament (31) and of the second carbon fiber filament (32) cross each other.

12. The braided crucible preform according to any one of claims 1 to 3, wherein the three-dimensional braided body (1) comprises two-dimensional braided structures arranged along a radial direction, wherein an outer circumferential wall of an inner two-dimensional braided structure is fitted against an inner circumferential wall of an adjacent outer two-dimensional braided structure; and adjacent two two-dimensional braided structures are connected by needle-punching;
preferably, the fiber felt layer is disposed between adjacent two two-dimensional braided structures.

13. A method for manufacturing the braided crucible preform according to any one of claims 1 to 12, comprising:
S1: first laying an EVA needling pad on a wooden mold, then disposing a layer of fiber felt on the EVA needling pad, and alternately stacking the winding layers (5) and the fiber felt layers on the outside of the layer of fiber felt, so as to form an inner protective layer;
S2: sleeving the three-dimensional braided body (1) on an outside of the inner protective layer;
S3: alternately stacking the winding layers (5) and the fiber felt layers on an outside of the three-dimensional braided body (1) to form an outer protective layer, and disposing a layer of fiber felt on an outside of the outer protective layer; and
S4: performing needle-punching.

14. A carbon/carbon crucible, wherein the carbon/carbon crucible is obtained by sequentially subjecting the braided crucible preform according to any one of claims 1 to 12 to chemical vapor deposition and graphitization treatment.
